(19) Europäisches Patentamt
European Patent Office
Office européen des brevets

(11) EP 2 617 773 A1

(12) **EUROPEAN PATENT APPLICATION**

(43) Date of publication:
**24.07.2013 Bulletin 2013/30**

(51) Int Cl.:
***C08L 75/04*** *(2006.01)* ***B41N 3/00*** *(2006.01)*
***C08G 18/81*** *(2006.01)* ***G03F 7/035*** *(2006.01)*

(21) Application number: **13151431.7**

(22) Date of filing: **16.01.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **19.01.2012 JP 2012008903**

(71) Applicant: **Fujifilm Corporation**
**Minato-ku**
**Tokyo (JP)**

(72) Inventor: **Ushijima, Kenta**
**Shizuoka (JP)**

(74) Representative: **HOFFMANN EITLE**
**Patent- und Rechtsanwälte**
**Arabellastrasse 4**
**81925 München (DE)**

(54) **Resin composition for flexographic printing plate, laser-engraving type flexographic printing plate precursor and process for producing same, and flexographic printing plate and process for making same**

(57) Disclosed is a resin composition for a flexographic printing plate, comprising (Component A) a binder resin and (Component B) a compound represented by Formula (1) and/or Formula (2), Component B being contained at 1 to 50 parts by mass relative to 100 parts by mass of Component A,

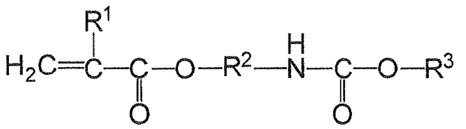 (1)

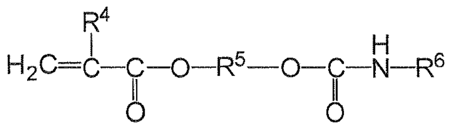 (2)

wherein in Formulae (1) and (2) $R^1$ and $R^4$ independently denote a hydrogen atom or a methyl group, $R^2$ and $R^5$ independently denote a divalent organic group having 1 to 20 carbons, and $R^3$ and $R^6$ independently denote a monovalent organic group having 1 to 20 carbons, $R^3$ and $R^6$ not comprising an ethylenically unsaturated group, a dialkoxysilyl group, or a trialkoxysilyl group.

EP 2 617 773 A1

## Description

The present invention relates to a resin composition for a flexographic printing plate, a laser-engraving type flexographic printing plate precursor and a process for producing same, and a flexographic printing plate and a process for making same.

A large number of so-called 'direct engraving CTP methods', in which a relief-forming layer is directly engraved by means of a laser are proposed. In the method, a laser light is directly irradiated to a flexographic printing plate precursor to cause thermal decomposition and volatilization by photothermal conversion, thereby forming a concave part in a relief-forming layer. Differing from a relief formation using an original image film, the direct engraving CTP method can control freely relief shapes. Consequently, when such image as an outline character is to be formed, it is also possible to engrave that region deeper than other regions, or, in the case of a fine halftone dot image, it is possible, taking into consideration resistance to printing pressure, to engrave while adding a shoulder. With regard to the laser for use in the method, a high-power carbon dioxide laser is generally used. In the case of the carbon dioxide laser, all organic compounds can absorb the irradiation energy and convert it into heat. On the other hand, inexpensive and small-sized semiconductor lasers have been developed, wherein, since they emit visible lights and near infrared lights, it is necessary to absorb the laser light and convert it into heat.

As a resin composition for laser engraving, those described in JP-A-2009-190332, JP-B-28546954, JP-B-4375705, or JP-T-2011-510839 are known. JP-A denotes a Japanese unexamined patent application publication, JP-B denotes a Japanese examined patent application publication, and JP-T denotes a published Japanese translation of a PCT application.

It is an object of the present invention to provide a resin composition for a flexographic printing plate that can give a cured film having a low Tg, excellent water resistance and solvent resistance, and excellent printing durability, a laser-engraving type flexographic printing plate precursor employing the resin composition for a flexographic printing plate and a process for producing same, a process for making a flexographic printing plate employing the printing plate precursor, and a flexographic printing plate obtained thereby.

The above-mentioned object of the present invention has been attained by solution means <1>, <10> to <12>, <14>, and <15> below. They are described below together with <2> to <9>, and <13>, which are preferred embodiments.

<1> A resin composition for a flexographic printing plate, comprising (Component A) a binder resin and (Component B) a compound represented by Formula (1) and/or Formula (2), Component B being contained at 1 to 50 parts by mass relative to 100 parts by mass of Component A

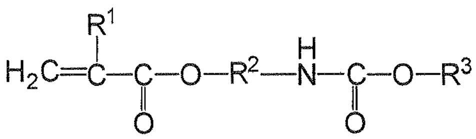 (1)

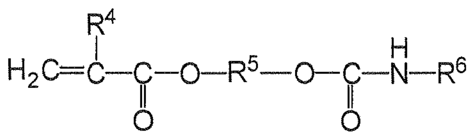 (2)

(in Formulae (1) and (2) $R^1$ and $R^4$ independently denote a hydrogen atom or a methyl group, $R^2$ and $R^5$ independently denote a divalent organic group having 1 to 20 carbons, and $R^3$ and $R^6$ independently denote a monovalent organic group having 1 to 20 carbons, $R^3$ and $R^6$ not comprising an ethylenically unsaturated group, a dialkoxysilyl group, or a trialkoxysilyl group),

<2> the resin composition for a flexographic printing plate according to <1>, wherein Component A comprises a urethane bond,

<3> the resin composition for a flexographic printing plate according to <1> or <2>, wherein Component A comprises an ethylenically unsaturated group, a dialkoxysilyl group, or a trialkoxysilyl group,

<4> the resin composition for a flexographic printing plate according to any one of <1> to <3>, wherein Component A is a plastomer at 20°C,

<5> the resin composition for a flexographic printing plate according to any one of <1> to <4>, wherein Component A has a (meth)acryloyloxy group at both main chain termini,

<6> the resin composition for a flexographic printing plate according to any one of <1> to <5>, wherein it further comprises (Component C) a photothermal conversion agent,

<7> the resin composition for a flexographic printing plate according to <6>, wherein Component C is carbon black,

<8> the resin composition for a flexographic printing plate according to any one of <1> to <7>, wherein it further comprises a polymerization initiator,

<9> the resin composition for a flexographic printing plate according to any one of <1> to <8>, wherein it is a resin composition for a laser-engraving type flexographic printing plate,

<10> a laser-engraving type flexographic printing plate precursor comprising a relief-forming layer comprising the

resin composition for a flexographic printing plate according to any one of <1> to <9>,

<11> a laser-engraving type flexographic printing plate precursor comprising a crosslinked relief-forming layer formed by crosslinking by means of light and/or heat a relief-forming layer comprising the resin composition for a flexographic printing plate according to any one of <1> to <9>,

<12> a process for producing a laser-engraving type flexographic printing plate precursor, the process comprising a layer formation step of forming a relief-forming layer comprising the resin composition for a flexographic printing plate according to any one of <1> to <9> and a crosslinking step of crosslinking by means of light and/or heat the relief-forming layer to thus obtain a flexographic printing plate precursor comprising a crosslinked relief-forming layer,

<13> the process for producing a laser-engraving type flexographic printing plate precursor according to <12>, wherein the crosslinking step is a step of crosslinking the relief-forming layer by means of heat to thus obtain a flexographic printing plate precursor comprising a crosslinked relief-forming layer,

<14> a process for making a flexographic printing plate comprising, in this order, a step of preparing a flexographic printing plate precursor for laser engraving comprising a crosslinked relief-forming layer formed by crosslinking by means of light and/or heat a relief-forming layer comprising the resin composition for a flexographic printing plate according to any one of <1> to <9> and an engraving step of laser-engraving the crosslinked relief-forming layer to thus form a relief layer, and

<15> use of the resin composition for a flexographic printing plate according to any one of <1> to <9> in a relief-forming layer of a flexographic printing plate precursor.

In accordance with the present invention, there can be provided a resin composition for a flexographic printing plate that can give a cured film having a low Tg, excellent water resistance and solvent resistance, and excellent printing durability, a laser-engraving type flexographic printing plate precursor employing the resin composition for a flexographic printing plate and a process for producing same, a process for making a flexographic printing plate employing the printing plate precursor, and a flexographic printing plate obtained thereby.

In the present invention, the notation 'lower limit to upper limit' expressing a numerical range means 'at least the lower limit but no greater than the upper limit', and the notation 'upper limit to lower limit' means 'no greater than the upper limit but at least the lower limit'. That is, they are numerical ranges that include the upper limit and the lower limit. Further, "(Component A) a binder polymer" etc. are simply called as "Component A" etc.

In the present invention, 'mass%' is the same meaning as 'weight%', and 'parts by mass' is the same meaning as 'parts by weight'.

In the present invention, '(meth)acrylate' means each one or both of 'acrylate' and 'methacrylate'.

The present invention is explained in detail below.

(Resin composition for flexographic printing plate)

The resin composition for a flexographic printing plate (hereinafter, also called simply a 'resin composition') of the present invention comprises (Component A) a binder resin and (Component B) a compound represented by Formula (1) and/or Formula (2), Component B being contained at 1 to 50 parts by mass relative to 100 parts by mass of Component A.

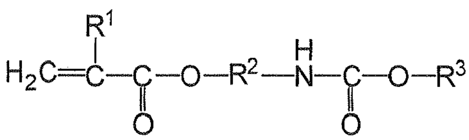 (1)

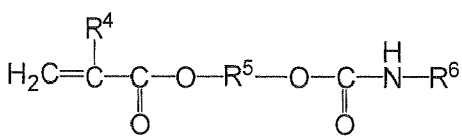 (2)

(In Formulae (1) and (2) $R^1$ and $R^4$ independently denote a hydrogen atom or a methyl group, $R^2$ and $R^5$ independently denote a divalent organic group having 1 to 20 carbons, and $R^3$ and $R^6$ independently denote a monovalent organic group having 1 to 20 carbons, $R^3$ and $R^6$ not comprising an ethylenically unsaturated group, a dialkoxysilyl group, or a trialkoxysilyl group.)

The resin composition for a flexographic printing plate of the present invention is preferably a resin composition for a laser-engraving type flexographic printing plate (hereinafter, also simply called a laser-engraving type resin composition) used particularly preferably in applications of a flexographic printing plate precursor having a relief-forming layer in which a relief layer is formed by laser engraving, but it may be used, without any particular limitation, in a wide range of applications other than application in a relief-forming layer.

For example, it may be applied not only to the relief-forming layer of a printing plate precursor that is subjected to raised relief formation by laser engraving, which will be described in detail below, but also to the formation of other products in which asperities or openings are formed on the surface, for example, various printing plates and various

formed bodies in which images are formed by laser engraving such as an intaglio plate, a stencil plate and a stamp.

Among them, it is preferable to apply to the formation of relief-forming layer equipped above an appropriate substrate.

The relief layer formed by using the resin composition for a flexographic printing plate of the present invention has advantages that a cured film has a low Tg, and the relief layer has no problem of ink adequency caused by elution of a plasticizer, etc. to the ink, with excellent flexibility.

In the present specification, when a flexographic printing plate precursor is explained, a layer that comprises a binder resin, that serves as an image-forming layer subjected to laser engraving, that has a flat surface, and that is an uncrosslinked crosslinkable layer is called a relief-forming layer, a layer that is formed by crosslinking the relief-forming layer is called a crosslinked relief-forming layer, and a layer that has asperities formed on the surface by laser engraving the crosslinked relief-forming layer is called a relief layer.

Constituent components of the resin composition for a flexographic printing plate are explained below.

(Component A) Binder resin

The resin composition for a flexographic printing plate of the present invention comprises (Component A) a binder resin.

Component A is explained in detail below.

Component A preferably has a number-average molecular weight (Mn) of at least 5,000, preferably comprises at least one chemical bond selected from the group consisting of a urethane bond, a siloxane bond, and a carbonate bond, and more preferably comprises a urethane bond. It is preferable for the binder resin to comprise a urethane bond since printing durability is excellent due to hydrogen bonding between binder molecules.

Component A is a resin having a number-average molecular weight of preferably at least 5,000 but no greater than 300,000, more preferably at least 6,000 but no greater than 250,000, and yet more preferably at least 6,000 but no greater than 200,000. It is preferable for the number-average molecular weight to be at least 5,000 since the printing plate precursor and the printing plate have improved strength and tend to withstand repeated use. On the other hand, when it is no greater than 300,000, since the viscosity when molding the resin composition does not increase excessively, the printing plate precursor and the printing plate tend to be able to be produced more easily, which is preferable. The number-average molecular weight (Mn) referred to here is a value obtained by measuring using gel permeation chromatography (GPC) and calibrating with polystyrene having a known molecular weight.

Furthermore, Component A preferably has an ethylenically unsaturated group in the molecule. Component A preferably has at least 0.3 ethylenically unsaturated groups on average per molecule. When it has at least 0.3 ethylenically unsaturated groups on average per molecule, the printing plate precursor and the printing plate have improved mechanical strength, and the durability is also good. Furthermore, when the mechanical strength of the printing plate precursor and the printing plate is taken into consideration, the number of ethylenically unsaturated groups in Component A is preferably at least 0.5 per molecule, and more preferably at least 0.7. From the viewpoint of the mechanical properties of a cured resin being improved and the ease of the process of introducing an ethylenically unsaturated group, the number of ethylenically unsaturated groups in Component A is preferably no greater than 2 per molecule. The 'ethylenically unsaturated group' referred to here means a polymerizable functional group involved in a radical polymerization reaction. With regard to the position of the ethylenically unsaturated group, it is preferable that it is directly bonded to a terminal of a polymer main chain or a polymer side chain or within a polymer main chain or a side chain. Among them, from the viewpoint of the molecular weight between crosslinked points being uniform and the film strength being excellent, the ethylenically unsaturated group is preferably present at both termini of a polymer main chain. The average number of ethylenically unsaturated groups contained in one Component A molecule may be determined by molecular structural analysis using nuclear magnetic resonance spectroscopy (NMR spectroscopy).

Examples of the ethylenically unsaturated group include a group formed from an unsaturated carboxylic acid as a starting material, such as an acryloyl group, a methacryloyl group, an acrylamide group, a methacrylamide group, or a phthalimide group, and a radically polymerizable group such as a styryl group, a vinyl group, or an allyl group. Among them, an acryloyl group and a methacryloyl group are particularly preferable.

Moreover, Component A is also preferably a binder resin having a dialkoxysilyl group or a trialkoxysilyl group in the molecule.

The alkoxy group of the dialkoxysilyl group and the trialkoxysilyl group is independently preferably an alkoxy group having 1 to 5 carbons, more preferably an alkoxy group having 1 to 3 carbons, and yet more preferably a methoxy group or an ethoxy group.

With regard to the position of the dialkoxysilyl group and the trialkoxysilyl group, it is preferably bonded to a side chain terminal or a main chain terminal of Component A.

With regard to a method for obtaining Component A, a method for obtaining a polyurethane resin, which is the basic skeleton, is first explained, and a method for introducing an ethylenically unsaturated group, a dialkoxysilyl group,

or a trialkoxysilyl group into a polyurethane resin skeleton is then explained.

The basic skeleton of Component A is preferably a polyurethane resin that is the product of a reaction between at least one type of diisocyanate compound represented by Formula (I) below and at least one type of diol compound represented by Formula (II) below. A synthetic method employing a known polyaddition reaction may be used for obtaining the polyurethane resin. Examples include synthetic methods described in Examples 1 to 7 of JP-A-2011-136430.

$$OCN\text{-}X^0\text{-}NCO \qquad (I)$$

$$HO\text{-}Y^0\text{-}OH \qquad (II)$$

In Formula (I) and Formula (II), $X^0$ and $Y^0$ independently denote a divalent organic group.

As a method for introducing an ethylenically unsaturated group, a dialkoxysilyl group, or a trialkoxysilyl group into Component A, there can be used a method in which, as a starting material for obtaining the polyurethane resin, a diisocyanate compound or diol compound already having an ethylenically unsaturated group, a dialkoxysilyl group, or a trialkoxysilyl group is used, and a polyurethane resin is formed by a polyaddition reaction of these starting materials, a method in which after a polyurethane resin having a bonding group such as a hydroxy group or an isocyanate group at a main chain terminal is obtained, this is reacted with an organic compound having an ethylenically unsaturated group, a dialkoxysilyl group, or a trialkoxysilyl group and a functional group that can react with this terminal bonding group to thus introduce an ethylenically unsaturated group, a dialkoxysilyl group, or a trialkoxysilyl group at a main chain terminal of Component A, etc.

«Diisocyanate compound»

The diisocyanate compound represented by Formula (I) used in synthesis of Component A used in the present invention is now explained.

In Formula (I) above, $X^0$ denotes an optionally substituted divalent aliphatic or aromatic hydrocarbon group. As necessary, $X^0$ may have a functional group that does not react with an isocyanate group, such as for example an ester bond, a urethane bond, an amide bond, or a ureido group.

Examples of the diisocyanate compound include an aliphatic diisocyanate compound, an alicyclic diisocyanate compound, an aromatic-aliphatic diisocyanate compound, and an aromatic diisocyanate compound.

Examples of the aliphatic diisocyanate compound include 1,3-trimethylene diisocyanate, 1,4-tetramethylene diisocyanate, 1,3-pentamethylene diisocyanate, 1,5-pentamethylene diisocyanate, 1,6-hexamethylene diisocyanate, 1,2-propylene diisocyanate, 1,2-butylene diisocyanate, 2,3-butylene diisocyanate, 1,3-butylene diisocyanate, 2-methyl-1,5-pentamethylene diisocyanate, 3-methyl-1,5-pentamethylene diisocyanate, 2,4,4-trimethyl-1,6-hexamethylene diisocyanate, 2,2,4-trimethyl-1,6-hexamethylene diisocyanate, 2,6-diisocyanate methyl caproate, and lysine diisocyanate.

Examples of the alicyclic diisocyanate compound include 1,3-cyclopentane diisocyanate, 1,4-cyclohexane diisocyanate, 1,3-cyclohexane diisocyanate, 3-isocyanatomethyl-3,5,5-trimethylcyclohexyl isocyanate, 4,4'-methylenebis (cyclohexyl isocyanate), methyl-2,4-cyclohexane diisocyanate, methyl-2,6-cyclohexane diisocyanate, 1,3-bis(isocyanatomethyl)cyclohexane, 1,4-bis(isocyanatomethyl)cyclohexane, isophorone diisocyanate, and norbornane diisocyanate.

Examples of the aromatic-aliphatic diisocyanate compound include 1,3-xylene diisocyanate, 1,4-xylene diisocyanate, ω,ω'-diisocyanato-1,4-diethylbenzene, 1,3-bis(1-isocyanato-1-methylethyl)benzene, 1,4-bis(1-isocyanato-1-methylethyl)benzene, and 1,3-bis(α,α-dimethylisocyanatomethyl)benzene.

Examples of the aromatic diisocyanate compound include *m*-phenylene diisocyanate, *p*-phenylene diisocyanate, 2,4-tolylene diisocyanate, 2,6-tolylene diisocyanate, 1,4-naphthylene diisocyanate, 1,5-naphthylene diisocyanate, 4,4'-diphenyl diisocyanate, 4,4'-diphenylmethane diisocyanate, 2,4'-diphenylmethane diisocyanate, 4,4'-diphenyl ether diisocyanate, 2-nitrodiphenyl-4,4'-diisocyanate, 2,2'-diphenylpropane-4,4'-diisocyanate, 3,3'-dimethyldiphenylmethane-4,4'-diisocyanate, 4,4'-diphenylpropane diisocyanate, 2,2-bis(*p*-isocyanatophenyl)propane, and 3,3'-dimethoxydiphenyl-4,4'-diisocyanate. Among them, 2,4-tolylene diisocyanate is particularly preferable.

<<Diol compound>>

The diol compound represented by Formula (II) used in synthesis of Component A used in the present invention is now explained.

Preferred examples of the diol compound include the straight-chain aliphatic diols, branched aliphatic diols, cyclic aliphatic diols, and aromatic-aliphatic diols below.

Examples of the straight-chain aliphatic diol include a straight-chain aliphatic diol having 3 to 50 carbons such as 1,3-propanediol, 1,4-butanediol, 1,5-pentanediol, 1,6-hexanediol, 1,7-heptanediol, 1,8-octanediol, 1,9-nonanediol,

1,10-decanediol, 1,12-dodecanediol, 1,16-hexadecanediol, or 1,20-eicosanediol.

Examples of the branched aliphatic diol include a branched aliphatic diol having 3 to 30 carbons such as 2-methyl-1,3-propanediol, 2-ethyl-1,3-propanediol, neopentyl glycol, 2,2-diethyl-1,3-propanediol, 2-methyl-2-propyl-1,3-propanediol, 2-butyl-2-ethyl-1,3-propanediol, 2,2-dibutyl-1,3-propanediol, 1,2-butanediol, 2-ethyl-1,4-butanediol, 2-isopropyl-1,4-butanediol, 2,3-dimethyl-1,4-butanediol, 2,3-diethyl-1,4-butanediol, 3,3-dimethyl-1,2-butanediol, pinacol, 1,2-pentanediol, 1,3-pentanediol, 2,3-pentanediol, 2-methyl-2,4-pentanediol, 3-methyl-1,5-pentanediol, 2-ethyl-1,5-pentanediol, 3-ethyl-1,5-pentanediol, 2-isopropyl-1,5-pentanediol, 3-isopropyl-1,5-pentanediol, 2,4-dimethyl-1,5-pentanediol, 2,4-diethyl-1,5-pentanediol, 2,3-dimethyl-1,5-pentanediol, 2,2,3-trimethyl-1,3-pentanediol, 1,2-hexanediol, 1,3-hexanediol, 1,4-hexanediol, 2,5-hexanediol, 2-ethyl-1,6-hexanediol, 2-ethyl-1,3-hexanediol, 2-isopropyl-1,6-hexanediol, 2,4-diethyl-1,6-hexanediol, 2,5-dimethyl-2,5-hexanediol, 2-methyl-1,8-octanediol, 2-ethyl-1,8-octanediol, 2,6-dimethyl-1,8-octanediol, 1,2-decanediol, or 8,13-dimethyl-1,20-eicosanediol.

Examples of the cyclic aliphatic diol or aromatic-aliphatic diol include a diol having 3 to 40 carbons such as 1,2-cyclohexanediol, 1,3-cyclohexanediol, 1,4-cyclohexanediol, 1,2-cyclohexanedimethanol, 1,3-cyclohexanedimethanol, 1,4-cyclohexanedimethanol, *m*-xylene-$\alpha,\alpha'$-diol, *p*-xylene-$\alpha,\alpha'$-diol, 2,2-bis(4-hydroxycyclohexyl)propane, 2,2-bis(4-hydroxyphenyl)propane, or dimer diol.

Preferred examples of the diol compound include the dilo compound having a carbonate bond. Examples of the diol compound having a carbonate bond include aliphatic polycarbonate diols such as 4,6-polyalkylene carbonate diol, 8,9-polyalkylene carbonate diol, and 5,6-polyalkylene carbonate diol. Furthermore, aliphatic polycarbonate diols having an aromatic ring in the molecule may also be used.

It is also preferable for Component A to have a siloxane bond in the main chain. A siloxane bond means a molecular structure in which silicon (Si) and oxygen (O) are alternately bonded. It is preferable that the main chain in the resin having a siloxane bond contains a silicone compound represented by following Mean Composition Formula (A).

$$R_pQ_rX_sSiO_{(4-p-r-s)/2} \qquad (A)$$

In Formula (A), R represents one kind or two or more kinds of hydrocarbon groups selected from the group consisting of a linear or branched alkyl group having 1 to 30 carbon atoms, a cycloalkyl group having 5 to 20 carbon atoms, an alkyl group having 1 to 30 carbon atoms (carbon number before substitution) substituted with an alkoxy group having 1 to 20 carbon atoms or aryl group having 6 to 20 carbon atoms, an aryl group having 6 to 20 carbon atoms substituted with a halogen atom, an alkoxycarbonyl group having 2 to 30 carbon atoms, a monovalent group containing a carboxyl group or a salt thereof, a monovalent group containing a sulfo group or a salt thereof, and a polyoxyalkylene group; Q and X each independently represent one kind or two or more kinds of a hydrogen atom or hydrocarbon groups selected from the group consisting of a linear or branched alkyl group having 1 to 30 carbon atoms, a cycloalkyl group having 5 to 20 carbon atoms, an alkyl group having 1 to 30 carbon atoms substituted with an alkoxy group or aryl group having 1 to 20 carbon atoms, an aryl group having 6 to 20 carbon atoms substituted with a halogen atom, an alkoxycarbonyl group having 2 to 30 carbon atoms, a monovalent group containing a carboxyl group or a salt thereof, a monovalent group containing a sulfo group or a salt thereof, and a polyoxyalkylene group; and p, r and s represent numbers satisfying the relations:

$0<p<4$,
$0 \leq r < 4$, 0,
$0 \leq s<4$, and
$(p+r+s) < 4$.

Examples of the compound for introducing a siloxane bond into Component A include silicone oils. Examples of the silicone oils include organopolysiloxanes having from low viscosity to high viscosity, such as dimethylpolysiloxane, methylphenylpolysiloxane, methylhydrogenpolysiloxane, and dimethylsiloxane-methylphenylsiloxane copolymers; cyclic siloxanes such as octamethylcyclotetrasiloxane, decamethylcyclopentasiloxane, dodecamethylcyclohexasiloxane, tetramethyltetrahydrogencyclotetrasiloxane, and tetramethyltetraphenylcyclotetrasiloxane; silicone rubbers such as gum-like dimethylpolysiloxane having a high degree of polymerization, and gum-like dimethylsiloxane-methylphenylsiloxane copolymers; cyclic siloxane solutions of the silicone rubber; trimethylsiloxysilicic acid; cyclic ciloxane solution of trimethylsiloxysilicic acid; higher alkoxy-modified silicones such as stearoxysilicone; and higher fatty acid-modified silicones.

Among them, silicone oils having reactivity are preferable. Examples include monoamine-modified silicone oil, diamine-modified silicone oil, special amino-modified silicone oil, epoxy-modified silicone oil, alicyclic epoxy-modified silicone oil, carbinol-modified silicone oil, mercapto-modified silicone oil, carboxy-modified silicone oil, hydrogen-modified silicone oil, amino · polyether-modified silicone oil, epoxy·polyother-modified silicone oil, epoxy · aralkyl-modified silicone oil, reactive silicone oil, methacrylic-modified silicone oil, polyether-modified silicone oil, mercapto-modified silicone oil,

phenol-modified silicone oil, silanol-modified silicon oil, fluorine-modified silicone oil, side chain amino-both end methoxy-modified silicone oil, and diol-modified silicone oil. When these silicone oils having reactivity are used, the introduction of a siloxane bond to Component A is facilitated.

Among the silicone oils having reactivity, both end-modified silicone oil is preferred. Examples include both end amino-modified silicone oil, both end epoxy-modified silicone oil, both end alicyclic epoxy-modified silicone oil, both end carbinol-modified silicone oil, both end methacrylic-modified silicone oil, both end polyether-modified silicone oil, both end mercapto-modified silicone oil, both end carboxy-modified silicone oil, both end phenol-modified silicone oil, and both end silanol-modified silicone oil.

In accordance with the use of such a both-termini type silicone oil, it becomes easy to introduce a siloxane bond into a main chain of Component A, and since it also has a reactive functional group at both termini it becomes easy to adjust the molecular weight. Among them, a both-termini carbinol-modified silicone oil is particularly preferable.

Furthermore, the number-average molecular weight of a compound having a siloxane bond used for introducing a siloxane bond into a resin main chain is preferably at least 1,000 but no greater than 10,000, more preferably at least 2,000 but no greater than 7,000, and yet more preferably at least 3,000 but no greater than 6,000. When in this range, it is easy to handle the silicone compound due to flowability being maintained.

As a method for introducing an ethylenically unsaturated group at a terminal of Component A, a reaction between an ethylenically unsaturated group-containing isocyanate compound of Formula (2-e) below and a hydroxy group that is left at a terminal during the synthesis of Component A can be cited as a preferred example. The ethylenically unsaturated group-containing isocyanate compound is explained below.

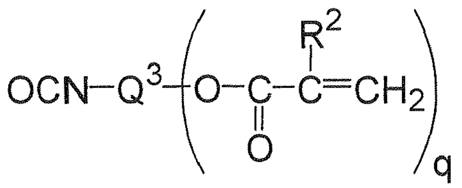
(2-e)

In Formula (2-e), $R^2$ denotes a hydrogen atom or a methyl group. $Q^3$ denotes a divalent or trivalent organic residue and denotes a hydrocarbon group having 1 to 10 carbons, which may be straight-chain, branched, or alicyclic, or an aromatic group having 6 to 20 carbons, and q is 1 or 2. When q is 1, $Q^3$ is preferably an alkylene group having 1 to 4 carbons and more preferably an ethylene group. When q is 2, $Q^3$ is preferably a trivalent branched hydrocarbon group having 3 to 6 carbons, and more preferably a trivalent branched hydrocarbon group having 4 carbons.

Examples of commercially available compoounds represented by Formula (2-e) include 2-methacryloyloxyethyl isocyanate (Karenz MOI (registered trademark)), 2-acryloyloxyethyl isocyanate (Karenz AOI (registered trademark)), and 1,1-(bisacryloyloxymothyl)ethyl isocyanate (Karenz BEI (registered trademark)) (all manufactured by Showa Denko K.K.).

As a method for introducing a dialkoxysilyl group or a trialkoxysilyl group at a terminal of Component A, a reaction between a compound of Formula (2-f) below and a hydroxy group that is left at a terminal during the synthesis of Component A can be cited as a preferred example. The compound of Formula (2-f) is explained below.

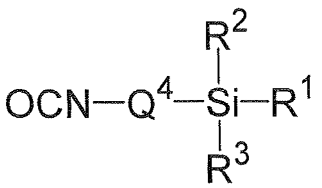
(2-f)

In Formula (2-f), $Q^4$ denotes a divalent organic residue and denotes a straight-chain, branched, or alicyclic hydrocarbon group having 1 to 10 carbons or an aromatic group having 6 to 20 carbons, at least two of $R^1$ to $R^3$ independently denote an alkoxy group having 1 to 30 carbons, and the remainder denotes a hydrogen atom, a halogen atom, a hydroxy group, an alkyl group having 1 to 10 carbons, or an aryl group having 6 to 10 carbons.

In Formula (2-f), $Q^4$ is preferably an alkylene group having 2 to 4 carbons. $R^1$ to $R^3$ are preferably independently alkoxy groups having 1 to 5 carbons, more preferably alkoxy groups having 1 to 3 carbons, and yet more preferably methoxy groups or ethoxy groups.

With regard to the compound represented by Formula (2-f), 3-(triethoxysilyl)propyl isocyanate may be obtained as a commercial product from Tokyo Chemical Industry Co., Ltd.

As an alternative method for introducing a dialkoxysilyl group or a trialkoxysilyl group at a terminal of Component A, a method in which Component A having an ethylenically unsaturated group at a terminal is reacted with a compound having for example a mercapto group, which reacts with the ethylenically unsaturated group, and having a dialkoxysilyl group or a trialkoxysilyl group can also be cited as a preferred example.

Examples of such a compound include 3-mercaptopropylmethyldimethoxysilane and 3-mercaptopropyltrimethoxysilane. These compounds may be obtained as KBM-802 and KBM-803 (registered trademarks) from Shin-Etsu Chemical Co., Ltd.

Component A preferably comprises a resin that is a plastomer at 20°C.

The term 'plastomer' as used in the present invention means, as described in 'Shinpan Kobunshi Jiten (Newly-published Polymer Encyclopedia) edited by the Society of Polymer Science, Japan (published in 1988 by Asakura Publishing Co., Ltd., Japan), a macromolecule which has a property of easily undergoing fluid deformation by heating and being capable of solidifying into a deformed shape by cooling. The term 'plastomer' is a term opposed to the term 'elastomer' (a polymer having a property of, when an external force is added, instantaneously deforming in accordance with the external force, and when the external force is removed, being restored to the original shape in a short time), and the plastomer does not exhibit the same elastic deformation as that exhibited by an elastomer, and easily undergoes plastic deformation.

In the present invention, a plastomer means a polymer which, when the original size is designated as 100%, can be deformed up to 200% of the original size by a small external force at room temperature (20°C), and even if the external force is removed, does not return to 130% or less of the original size. More particularly, the plastomer means a polymer with which, based on the tensile permanent strain test of JIS K 6262-1997, an I-shaped specimen can be extended to 2 times the gauge length before pulling in a tensile test at 20°C, and the tensile permanent strain measured after extending the specimen to 2 times the gauge length before pulling, subsequently maintaining the specimen for 5 minutes, removing the external tensile force, and maintaining the specimen for 5 minutes, is 30% or greater.

Meanwhile, in the case of a polymer that cannot be subjected to the measurement described above, a polymer which is deformed even if an external force is not applied and does not return to the original shape, corresponds to a plastomer, and for example, a syrup-like resin, an oil-like resin, and a liquid resin correspond thereto.

Furthermore, the plastomer according to the present invention is such that the glass transition temperature (Tg) of the polymer is lower than 20°C. In the case of a polymer having two or more Tg's, all the Tg's are lower than 20°C.

Of Component A, the proportion of the resin that is a plastomer at 20°C is preferably at least 50 mass%, more preferably at least 80 mass%, yet more preferably at least 90 mass%, and particularly preferably 100 mass%, that is, the entire amount of Component A being a plastomer at 20°C.

The viscosity of Component A at 20°C is preferably 10 Pa·s to 10 kPa·s, more preferably 30Pa·s to 7 kPa·s, and yet more preferably 50 Pa·s to 5 kPa·s.

When the viscosity is at least 10 Pa·s, a printing plate precursor that is obtained tends to have good mechanical strength, and when the viscosity is no greater than 10 kPa·s, it is easy to change the shape at normal temperature and it tends to be easy to form a relief-forming layer or mix with another composition.

With regard to Component A, a single type may be used or two or more types, that is, a plurality of types, may be used in combination.

The content of Component A in the resin composition for a flexographic printing plate of the present invention is preferably 2 to 95 mass% relative to the solids content total mass of the resin composition excluding volatile components such as solvent, and more preferably 50 to 80 mass%.

<(Component B) Compound represented by Formula (1) and/or Formula (2)>

The resin composition for a flexographic printing plate of the present invention comprises (Component B) a compound represented by Formula (1) and/or Formula (2). Component B may comprise either one of a compound represented by Formula (1) or a compound represented by Formula (2), or it may comprise both, and although there are no particular limitations it is preferable for it to comprise a compound represented by Formula (1) or a compound represented by Formula (2).

Component B is preferably a compound represented by Formula (1) or Formula (2) having a number-average molecular weight of less than 5,000, more preferably less than 1,000, and yet more preferably no greater than 500.

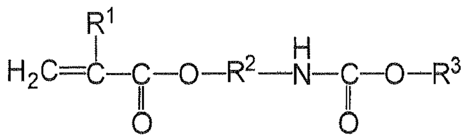 (1)

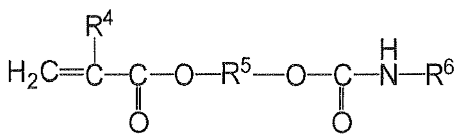 (2)

(In Formulae (1) and (2) $R^1$ and $R^4$ independently denote a hydrogen atom or a methyl group, $R^2$ and $R^5$ independently denote a divalent organic group having 1 to 20 carbons, and $R^3$ and $R^6$ independently denote a monovalent organic group having 1 to 20 carbons, $R^3$ and $R^6$ not comprising an ethylenically unsaturated group, a dialkoxysilyl group, or a trialkoxysilyl group.)

In Formulae (1) and (2), $R^1$ and $R^4$ independently denote a hydrogen atom or a methyl group, and particularly preferably a methyl group.

In Formulae (1) and (2), $R^2$ and $R^5$ independently denote a divalent organic group having 1 to 20 carbons. The divalent organic group having 1 to 20 carbons may comprise a straight-chain, branched, or cyclic structure. Furthermore, the organic group may be only a saturated hydrocarbon or may contain an unsaturated bond. It may contain in a carbon chain a heteroatom such as an oxygen atom, a sulfur atom, or a nitrogen atom. $R^2$ and $R^5$ are preferably straight-chain alkylene groups having 2 to 4 carbons, and particularly preferably an ethylene group or a propylene group.

In Formulae (1) and (2), $R^3$ and $R^6$, which do not contain an ethylenically unsaturated group, a dialkoxysilyl group, or a trialkoxysilyl group, independently denote a monovalent organic group having 1 to 20 carbons. The monovalent organic group having 1 to 20 carbons is preferably a hydrocarbon group and may comprise a straight-chain, branched, or cyclic structure. The hydrocarbon group having 1 to 20 carbons may contain in the carbon chain a bond selected from the group consisting of an ether bond, an ester bond, and an amide bond, and may contain a plurality of ethyleneoxy groups. Furthermore, it may contain in the carbon chain a heteroatom such as an oxygen atom, a sulfur atom, or a nitrogen atom. $R^3$ and $R^6$ are preferably hydrocarbon groups having 2 to 12 carbons, and more preferably a branched alkyl group such as 2-ethylhexyl, an alkoxycarbonylalkyl group such as a methoxyethoxyethoxyethyl group, or a polyethyleneoxy group.

It is surmised that, since compounds represented Formula (1) and by Formula (2) have a urethane bond in the molecule, they have good compatibility with Component A, and they have a plasticizer-like function for Component A. Furthermore, it is surmised that due to having an ethylenically unsaturated group, they are chemically bonded within a crosslinked structure, and leaching into an ink, etc. is suppressed.

Component B may preferably be synthesized by a condensation reaction between an isocyanate compound having a (meth)acryloyloxy group at a terminal and an alcohol compound or a condensation reaction between an alcohol compound having a (meth)acryloyloxy group at a terminal and an isocyanate compound.

Preferred examples of the isocyanate compound having a (meth)acryloyloxy group at a terminal as a starting material for Component B include 2-methacryloyloxyethyl isocyanate and 2-acryloyloxyethyl isocyanate. They are available as Karenz MOI and Karenz AOI (registered trademarks) from Showa Denko K.K.

Preferred examples of the alcohol compound having a (meth)acryloyloxy group at a terminal as a starting material for Component B include 2-hydroxyethyl methacrylate and hydroxypropyl methacrylate. They are available as the Blemmer E series, Blemmer P series, Blemmer PE series, Blemmer PP series, Blemmer 50PEP-300, Blemmer 70PEP-350B, Blemmer 55PET-800, Blemmer AE series, and Blemmer AP series from NOF Corporation.

Known compounds may be used as the alcohol compound and the isocyanate compound as starting materials for Component B.

Preferred specific examples of Component B include, but are not limited to, those shown below.

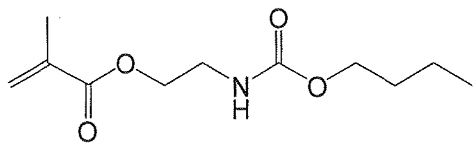

(B-1)

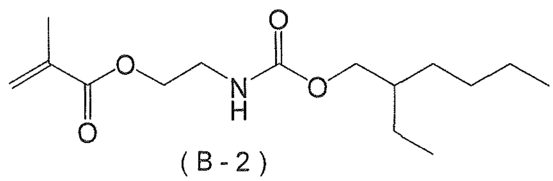

(B-2)

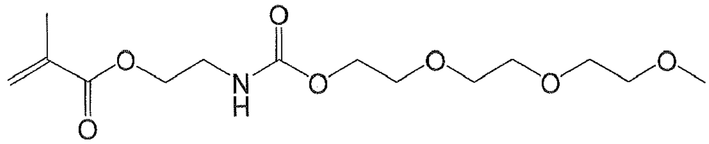

(B-3)

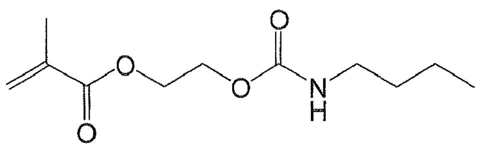

(B-4)

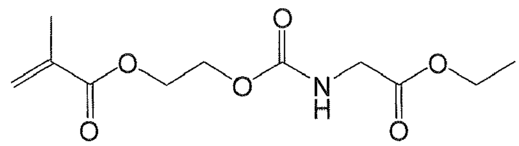

(B-5)

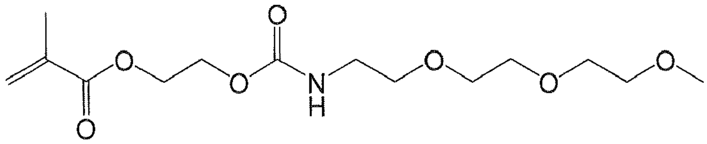

(B-6)

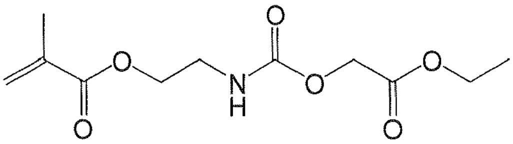

(B-7)

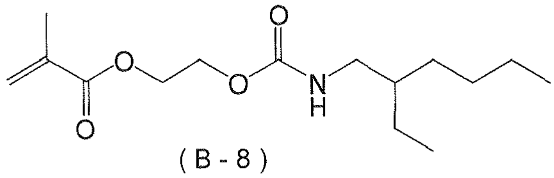

(B-8)

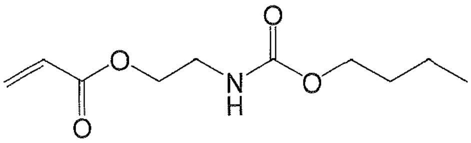

(B-9)

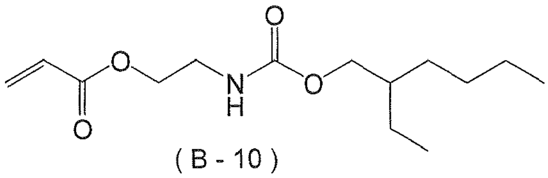

(B-10)

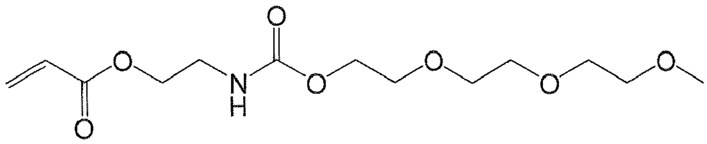

(B-11)

The content of Component B in the resin composition for a flexographic printing plate of the present invention is preferably 1 to 50 mass% relative to the solids content total mass, and more preferably 1 to 30 mass%.

Furthermore, with regard to the ratio (ratio by mass) of the content of Component B and the content of Component A, Component B is contained at 1 to 50 parts by mass relative to 100 parts by mass of Component A, preferably 10 to 40 parts by mass, and more preferably 10 to 30 parts by mass.

With regard to Component B, a single type may be used or two or more types may be used in combination.

<(Component C) Photothermal conversion agent>

The resin composition for a flexographic printing plate of the present invention preferably further comprises (Component C) a photothermal conversion agent. It is surmised that Component C in the present invention absorbs laser light and generates heat so as to promote thermal decomposition of a cured material at the time of laser engraving. Because of this, it is preferable to select a photothermal conversion agent that absorbs light having the wavelength of a laser used for engraving.

When a laser (a YAG laser, a semiconductor laser, a fiber laser, a surface emitting laser, etc.) emitting infrared at a wavelength of 700 to 1,300 nm is used as a light source for laser engraving the flexographic printing plate precursor for laser engraving obtained by using the resin composition of the present invention, it is preferable for the relief-forming layer in the present invention to comprise a photothermal conversion agent that has a maximun absorption wavelength at 700 to 1,300 nm.

As Component C used in the present invention, various types of dye or pigment are used.

With regard to Component C, examples of dyes that can be used include commercial dyes and known dyes described in publications such as 'Senryo Binran' (Dye Handbook) (Ed. by The Society of Synthetic Organic Chemistry, Japan, 1970). Specific preferred examples include dyes having a maximum absorption wavelength at 700 to 1,300 nm, such as azo dyes, metal complex salt azo dyes, pyrazolone azo dyes, naphthoquinone dyes, anthraquinone dyes, phthalocyanine dyes, carbonium dyes, diimmonium compounds, quinone imine dyes, methine dyes, cyanine dyes, squarylium colorants, pyrylium salts, and metal thiolate complexes. In particular, cyanine-based colorants such as heptamethine cyanine colorants, oxonol-based colorants such as pentamethine oxonol colorants, phthalocyanine-based colorants, and dyes described in paragraphs 0124 to 0137 of JP-A-2008-63554 are preferably used.

With regard to Component C used in the present invention, examples of pigments include commercial pigments and pigments described in the Color Index (C.I.) Handbook, 'Saishin Ganryo Binran' (Latest Pigments Handbook) (Ed.

by Nippon Ganryo Gijutsu Kyokai, 1977), 'Saisin Ganryo Ouyogijutsu' (Latest Applications of Pigment Technology) (CMC Publishing, 1986), 'Insatsu Inki Gijutsu' (Printing Ink Technology) (CMC Publishing, 1984). Examples include pigments described in paragraphs 0122 to 0125 of JP-A-2009-178869.

Among these pigments, carbon black is preferable.

Any carbon black, regardless of classification by ASTM and application (e.g. for coloring, for rubber, for dry cell, etc.), may be used as long as dispersibility, etc. in the composition is stable. Carbon black includes for example furnace black, thermal black, channel black, lamp black, and acetylene black. In order to make dispersion easy, a black colorant such as carbon black may be used as color chips or a color paste by dispersing it in nitrocellulose or a binder in advance using, as necessary, a dispersant, and such chips and paste are readily available as commercial products. Examples include carbon blacks described in paragraphs 0130 to 0134 of JP-A-2009-178869.

The content of Component C in the resin composition of the present invention largely depends on the size of the molecular extinction coefficient characteristic to the molecule, and is preferably 0.01 to 30 mass% relative to the solid total mass of the composition, more preferably 0.05 to 20 mass%, and yet more preferably 0.1 to 10 mass%.

<Solvent>

The resin composition for a flexographic printing plate of the present invention may comprise a solvent other than Component A and Component B. Since it is necessary for most of the solvent component to be removed in a stage of producing a flexographic printing plate precursor, the solvent is preferably a volatile low-molecular-weight alcohol (e.g. methanol, ethanol, n-propanol, isopropanol, propylene glycol monomethyl ether acetate), etc., and it is preferable to minimize the total amount of solvent added by adjusting the temperature, etc.

<Ethylenically unsaturated compound>

The resin composition for a flexographic printing plate of the present invention may comprise an ethylenically unsaturated compound other than Component A and Component B (hereinafter, also called a 'monomer' as appropriate).

The monomer is an organic compound that comprises at least one ethylenically unsaturated bond and can undergo an addition polymerization reaction by radical polymerization; it preferably comprises at least two ethylenically unsaturated bonds, and more preferably 2 to 6 ethylenically unsaturated bonds. Furthermore, the monomer is preferably a compound having an ethylenically unsaturated group at a molecular terminal. Moreover, the monomer preferably has a number-average molecular weight of less than 10,000, and more preferably less than 5,000. It is preferable for the monomer not to contain a urethane bond.

As the monomer, a known monomer may be used, and those described in paragraphs 0098 to 0124 of JP-A-2009-204962 and those described in JP-A-2009-255510 can be cited as examples.

Examples of ethylenically unsaturated compounds include unsaturated carboxylic acids (such as acrylic acid, methacrylic acid, itaconic acid, crotonic acid, isocrotonic acid and maleic acid), and esters and amides thereof. Preferably esters of an unsaturated carboxylic acid and an aliphatic polyhydric alcoholic compound, or amides of an unsaturated carboxylic acid and an aliphatic polyvalent amine compound are used. Moreover, addition reaction products of unsaturated carboxylic acid esters or amides having a nucleophilic substituent such as a hydroxyl group, an amino group, or a mercapto group with monofunctional or polyfunctional isocyanates or epoxies, and dehydrating condensation reaction products with a monofunctional or polyfunctional carboxylic acid, etc. are also used favorably. Moreover, addition reaction products of unsaturated carboxylic acid esters or amides having an electrophilic substituent such as an isocyanato group or an epoxy group with monofunctional or polyfunctional alcohols, amines, or tiols, and substitution reaction products of unsaturated carboxylic acid esters or amides having a leaving group such as a halogen group or a tosyloxy group with monofunctional or polyfunctional alcohols, amines, or tiols are also favorable. Moreover, as another example, the use of compounds obtained by replacing the unsaturated carboxylic acid with an unsaturated phosphonic acid, stylene, a vinyl ether compound or the like is also possible.

As examples of other esters, aliphatic alcohol-based esters described in JP-B-46-27926, JP-B-51-47334 and JP-A-57-196231, those having an aromatic skeleton described in JP-A-59-5240, JP-A-59-5241, and JP-A-2-226149, those having an amino group described in JP-A-1-165613, etc. may also be used preferably.

The above-mentioned ethylenically unsaturated compound other than Component A and Component B may be used singly or in a combination of two or more compounds.

The content of the ethylenically unsaturated compound other than Component A and Component B is preferably 0 to 60 mass% relative to the solids content total mass of the resin composition of the present invention, and more preferably 0 to 30 mass%. With regard to the ethylenically unsaturated compound other than Component A and Component B, a single type may be used or two or more types may be used in combination.

<Polymerization initiator>

The resin composition for a flexographic printing plate of the present invention preferably comprises a polymerization initiator.

As the polymerization initiator well-known examples among those known art may be used without particular limitations. Hereinafter, although the radical polymerization initiator which is a preferable polymerization initiator will be described, the present invention is not limited by this description.

Moreover, although the polymerization initiator may be a photopolymerization initiator or a thermopolymerization initiator (a thermal polymerization initiator), the polymerization initiator is preferably a thermopolymerization initiator.

In the present invention, preferable radical polymerization initiators include (a) aromatic ketones, (b) onium salt compounds, (c) organic peroxides, (d) thio compounds, (e) hexaallylbiimidazole compounds, (f) ketoxime ester compounds, (g) borate compounds, (h) azinium compounds, (i) metallocene compounds, (j) active ester compounds, (k) compounds having a carbon halogen bond, and (l) azo compounds. Hereinafter, although specific examples of the (a) to (l) are cited, the present invention is not limited to these.

In the present invention, when applies to the relief-forming layer of the flexographic printing plate precursor, from the viewpoint of printing durability and making a favorable relief edge shape, (c) organic peroxides and (l) azo compounds are more preferable, and (c) organic peroxides are particularly preferable.

The (a) aromatic ketones, (b) onium salt compounds, (d) thio compounds, (e) hexaallylbiimidazole compounds, (f) ketoxime ester compounds, (g) borate compounds, (h) azinium compounds, (i) metallocene compounds, (j) active ester compounds, and (k) compounds having a carbon halogen bonding may preferably include compounds described in paragraphs 0074 to 0118 of JP-A-2008-63554.

Organic peroxides and azo compounds are explained in detail below.

<<Organic peroxides>>

The resin composition of the present invention preferably comprises organic peroxides as the thermopolymerization initiator.

With regard to the organic peroxides, one type may be used on its own, or two or more types may be used in combination.

It is preferable for an organic peroxide to have a 10-hour half-life temperature of at least 60°C, more preferably at least 80°C, and particularly preferably at least 100°C. Furthermore, it is preferable for it to have a 10-hour half-life temperature of no greater than 220°C, more preferably no greater than 200°C, and particularly preferably no greater than 180°C.

It is preferable for the 10-hour half-life temperature to be in the above-mentioned range since the resin composition obtains sufficient crosslink density.

The 10-hour half-life temperature is measured as described in paragraphs 0047 of JP-A-2011-136431.

The organic peroxide is preferably a dialkyl peroxide, a peroxyketal, a peroxyester, a diacyl peroxide, an alkyl hydroperoxide, a peroxydicarbonate, or a ketone peroxide, and more preferably an organic peroxide selected from the group consisting of a dialkyl peroxide, a peroxyketal, and a peroxyester.

Examples of the dialkyl peroxide include di-*t*-butyl peroxide, di-*t*-hexyl peroxide, *t*-butylcumyl peroxide, dicumyl peroxide, $\alpha,\alpha'$-bis(*t*-butylperoxy)diisopropylbenzene, 2,5-dimethyl-2,5-bis(*t*-butylperoxy)hexane, and 2,5-dimethyl-2,5-bis(*t*-butylperoxy)hexyne-3.

Examples of the peroxyketal include *n*-butyl 4,4-bis(*t*-butylperoxy)valerate, 2,2-bis(*t*-butylperoxy)butane, 1,1-bis(*t*-butylperoxy)cyclohexane, 1,1-bis(*t*-hexylperoxy)cyclohexane, 1,1-bis(*t*-butylperoxy)-3,3,5-trimethylcyclohexane, and 1,1-bis(*t*-hexylperoxy)-3,3,5-trimethylcyclohexane.

Examples of the peroxyester include $\alpha$-cumyl peroxyneodecanoate, 1,1-dimethyl-3-hydroxybutyl peroxy-2-ethylhexanoate, *t*-amyl peroxybenzoate, *t*-butyl peroxybenzoate, and *t*-butyl peroxypivalate.

Furthermore, as the organic peroxide, a diacyl peroxide such as dibenzoyl peroxide, succinic acid peroxide, dilauroyl peroxide, or didecanoyl peroxide, an alkyl hydroperoxide such as 2,5-dihydroperoxy-2,5-dimethylhexane, cumene hydroperoxide, or *t*-butyl hydroperoxide, or a peroxydicarbonate such as di(*n*-propyl) peroxydicarbonate, di (*sec*-butyl) peroxydicarbonate, or di(2-ethylhexyl) peroxydicarbonate may also be used.

Organic peroxides are commercially available from, for example, NOF Corporation, Kayaku Akzo Corporation, etc.

«Azo compounds»

Preferable azo compounds as a thermopolymerization initiator that can be used in the present invention include those such as 2,2'-azobisisobutyronitrile, 2,2'-azobispropionitrile, 1,1'-azobis(cyclohexane-1-carbonitrile), 2,2'-azobis(2-methylbutyronitrile), 2,2'-azobis(2,4-dimethylvaleronitrile), 2,2'-azobis(4-methoxy-2,4-dimethylvaleronitrile), 4,4'-azobis (4-cyanovaleric acid), dimethyl 2,2'-azobis(isobutyrate), 2,2'-azobis(2-methylpropionamideoxime), 2,2'-azobis[2-(2-imidazolin-2-yl)propane], 2,2'-azobis{2-methyl-*N*-[1,1-bis(hydroxymethyl)-2-hydroxyethyl]propionamide}, 2,2'-azobis[2-methyl-*N*-(2-hydroxyethyl)propionamide], 2,2'-azobis(*N*-butyl-2-methylpropionamide), 2,2'-azobis(*N*-cyclohexyl-2-methylpropionamide), 2,2'-azobis[*N*-(2-propenyl)-2-methyl-propionamide], 2,2'-azobis(2,4,4-trimethylpentane).

With regard to the polymerization initiator in the present invention, one type may be used on its own or two or more types may be used in combination.

The content of the polymerization initiator in the resin composition for a flexographic printing plate is preferably 0.01 to 5 mass% relative to the total mass of the solids content of the resin composition excluding volatile components, and more preferably 0.1 to 3 wt%.

<<Alcohol exchange reaction catalyst>>

The resin composition of the present invention preferably comprises an alcohol exchange reaction catalyst in order to promote the formation of a crosslinked structure. The alcohol exchange reaction catalyst may be used without limitation as long as it is a reaction catalyst that is usually used in a silane coupling reaction, and is preferably at least one type selected from the group consisting of an acid, a base, and a metal complex.

Examples of the acid include a protonic acid (hydrochloric acid, sulfuric acid, phosphoric acid, etc.), a Lewis acid ($AlCl_3$, $ZnCl_2$, etc.), and a photo-acid generator.

Examples of the base include an inorganic base (NaOH, $Na_2CO_3$, etc.), a metal alkoxide ($CH_3ONa$, *t*-BuOK, etc.), and an amine.

Specific acid, base, and metal complex compounds that are representative alcohol exchange reaction catalysts are preferably compounds described in paragraphs 0060 to 0070 of JP-A-2011-136430.

The content of the alcohol exchange reaction catalyst in the resin composition for a flexographic printing plate of the present invention is preferably 0.1 to 5 mass% relative to the solids content total mass of the resin composition, and more preferably 0.3 to 3 mass%.

<Other additives>

The resin composition for a flexographic printing plate of the present invention may comprise as appropriate various types of known additives as long as the effects of the present invention are not inhibited. Examples include a filler, a wax, a metal oxide, an antiozonant, an anti-deterioration agent, a thermopolymerization inhibitor, a colorant, and a fragrance, and one type thereof may be used on its own or two more types may be used in combination.

(Glass transition temperature of cured film)

The resin composition for a flexographic printing plate of the present invention preferably has a low glass transition temperature for a cured film, and specifically it is preferably less than room temperature (20°C). It is more preferably no greater than 0°C, and yet more preferably no greater than -10°C. There is no particular lower limit for the glass transition temperature.

It is preferable for the glass transition temperature of a cured film that is obtained to be in this range since the flexibility is excellent.

With regard to the Tg of a cured film, the resin composition for a flexographic printing plate of the present invention is cast into a spacer (frame) provided on a PET substrate, dried, and thermally crosslinked to thus form a crosslinked film (thickness about 1 mm), and the crosslinked film thus formed is peeled off to give a sample. The temperature dependence of the storage modulus and the loss modulus is measured from -70°C to 100°C at 1 Hz using a Rheogel-E4000 (UBM), the temperature dependence of tan$\delta$ is determined from the storage modulus and the loss modulus, and the temperature at the top of the peak so obtained is defined as the Tg of the film.

<Process for producing laser-engraving type flexographic printing plate precursor>

Formation of a relief-forming layer in the laser-engraving type flexographic printing plate precursor is not particularly limited, and examples thereof include a method in which a resin composition is prepared, solvent is removed as necessary from this resin composition, and it is melt-extruded onto a support. Alternatively, a method may be employed in which the resin composition is cast onto a support, and this is dried in an oven to thus remove solvent from the resin composition.

Among them, the process for producing a laser-engraving type flexographic printing plate precursor of the present invention is preferably a production process comprising a layer formation step of forming a relief-forming layer

comprising the resin composition of the present invention and a crosslinking step of crosslinking the relief-forming layer by means of light and/or heat to thus obtain a flexographic printing plate precursor comprising a crosslinked relief-forming layer, and more preferably a production process comprising a layer formation step of forming a relief-forming layer comprising the resin composition for a flexographic printing plate of the present invention and a crosslinking step of crosslinking the relief-forming layer by means of heat to thus obtain a flexographic printing plate precursor comprising a crosslinked relief-forming layer.

Subsequently, as necessary, a protection film may be laminated on the relief-forming layer. Laminating may be carried out by compression-bonding the protection film and the relief-forming layer by means of heated calendar rollers, etc. or putting a protection film into intimate contact with a relief-forming layer whose surface is impregnated with a small amount of solvent.

When a protection film is used, a method in which a relief-forming layer is first layered on a protection film and a support is then laminated may be employed.

When an adhesive layer is provided, it may be dealt with by use of a support coated with an adhesive layer. When a slip coat layer is provided, it may be dealt with by use of a protection film coated with a slip coat layer.

<Layer formation step>

The process for making the laser-engraving type flexographic printing plate precursor of the present invention preferably comprises a layer formation step of forming a relief-forming layer from the resin composition of the present invention.

Preferred examples of a method for forming a relief-forming layer include a method in which the resin composition of the present invention is prepared, solvent is removed as necessary from the resin composition, and it is then melt-extruded onto a support and a method in which the resin composition is prepared, the resin composition of the present invention is cast onto a support, and this is dried in an oven to thus remove the solvent.

The resin composition for a laser engraving type flexographic printing plate may be produced by, for example, dissolving or dispersing Component A and Component B, and optional components in an appropriate solvent.

The thickness of the (crosslinked) relief-forming layer of the laser-engraving type flexographic printing plate precursor before and after crosslinking is preferably at least 0.05 mm but no greater than 10 mm, more preferably at least 0.05 mm but no greater than 7 mm, and yet more preferably at least 0.05 mm but no greater than 3 mm.

<Crosslinking step>

The process for producing a laser-engraving type flexographic printing plate precursor of the present invention is preferably a production process comprising a crosslinking step of crosslinking the relief-forming layer by means of light and/or heat to thus obtain a flexographic printing plate precursor having a crosslinked relief-forming layer.

When the relief-forming layer comprises a photopolymerization initiator, the relief-forming layer may be crosslinked by irradiating the relief-forming layer with actinic radiation that triggers the photopolymerization initiator.

It is preferable to apply light to the entire surface of the relief-forming layer. Examples of the light (also called 'actinic radiation') include visible light, UV light, and an electron beam, but UV light is most preferably used. When the side where there is a substrate, such as a relief-forming layer support, for fixing the relief-forming layer, is defined as the reverse face, only the front face need be irradiated with light, but when the support is a transparent film through which actinic radiation passes, it is preferable to further irradiate the reverse face with light as well. When a protection film is present, irradiation from the front face may be carried out with the protection film as it is or after peeling off the protection film. Since there is a possibility of polymerization being inhibited in the presence of oxygen, irradiation with actinic radiation may be carried out after superimposing a polyvinyl chloride sheet on the relief-forming layer and evacuating.

When the relief-forming layer comprises a thermopolymerization initiator (it being possible for the photopolymerization initiator to function also as a thermopolymerization initiator), the relief-forming layer may be crosslinked by heating the laser-engraving type flexogaphic printing plate precursor (step of crosslinking by means of heat). As heating means, there can be cited a method in which a printing plate precursor is heated in a hot air oven or a far-infrared oven for a predetermined period of time and a method in which it is put into contact with a heated roller for a predetermined period of time.

As a method for crosslinking the relief-forming layer, from the viewpoint of the relief-forming layer being uniformly curable (crosslinkable) from the surface into the interior, crosslinking by heat is preferable.

Due to the relief-forming layer being crosslinked, firstly, a relief formed after laser engraving becomes sharp and, secondly, tackiness of engraving residue formed when laser engraving is suppressed. If an uncrosslinked relief-forming layer is laser-engraved, residual heat transmitted to an area around a laser-irradiated part easily causes melting or deformation of a part that is not targeted, and a sharp relief layer cannot be obtained in some cases. Furthermore, in

terms of the general properties of a material, the lower the molecular weight, the more easily it becomes a liquid rather than a solid, that is, there is a tendency for tackiness to be stronger. Engraving residue formed when engraving a relief-forming layer tends to have higher tackiness the more that low-molecular-weight materials are used. Since a polymerizable compound, which is a low-molecular-weight material, becomes a polymer by crosslinking, the tackiness of the engraving residue formed tends to decrease.

When the crosslinking step is a step of carrying out crosslinking by light, although equipment for applying actinic radiation is relatively expensive, since a printing plate precursor does not reach a high temperature, there are hardly any restrictions on starting materials for the printing plate precursor.

When the crosslinking step is a step of carrying out crosslinking by heat, although there is the advantage that particularly expensive equipment is not needed, since a printing plate precursor reaches a high temperature, it is necessary to carefully select the starting materials used while taking into consideration the possibility that a thermoplastic polymer, which becomes soft at high temperature, will deform during heating, etc.

During thermal crosslinking, it is preferable to add a thermopolymerization initiator. As the thermopolymerization initiator, a commercial thermopolymerization initiator for free radical polymerization may be used. Examples of such a thermopolymerization initiator include an appropriate peroxide, hydroperoxide, and azo group-containing compound. A representative vulcanizing agent may also be used for crosslinking. Thermal crosslinking may also be carried out by adding a heat-curable resin such as for example an epoxy resin as a crosslinking component to a layer.

(Flexographic printing plate and process for making same)

The process for making a flexographic printing plate of the present invention preferably comprises a layer formation step of forming a relief-forming layer from the resin composition of the present invention, a crosslinking step of crosslinking the relief-forming layer by means of heat and/or light to thus obtain a flexographic printing plate precursor having a crosslinked relief-forming layer, and an engraving step of laser-engraving the flexographic printing plate precursor having the crosslinked relief-forming layer, and more preferably comprises a layer formation step of forming a relief-forming layer from the resin composition of the present invention, a crosslinking step of crosslinking the relief-forming layer by means of heat to thus obtain a flexographic printing plate precursor having a crosslinked relief-forming layer, and an engraving step of laser-engraving the flexographic printing plate precursor having the crosslinked relief-forming layer.

The flexographic printing plate of the present invention is a flexographic printing plate having a relief layer obtained by crosslinking and laser-engraving a layer formed from the resin composition of the present invention, and is preferably a flexographic printing plate made by the process for making a flexographic printing plate of the present invention.

The flexographic printing plate of the present invention is suitable for printing a variety of inks.

The layer formation step and the crosslinking step in the process for making a flexographic printing plate of the present invention mean the same as the layer formation step and the crosslinking step in the above-mentioned process for producing a laser-engraving type flexographic printing plate precursor, and preferred ranges are also the same.

<Engraving step>

The process for making a flexographic printing plate of the present invention preferably comprises an engraving step of laser-engraving the flexographic printing plate precursor having a crosslinked relief-forming layer.

The engraving step is a step of laser-engraving a crosslinked relief-forming layer that has been crosslinked in the crosslinking step to thus form a relief layer. Specifically, it is preferable to engrave a crosslinked relief-forming layer that has been crosslinked by irradiation with laser light according to a desired image, thus forming a relief layer. Furthermore, a step in which a crosslinked relief-forming layer is subjected to scanning irradiation by controlling a laser head using a computer in accordance with digital data of a desired image can preferably be cited.

This engraving step preferably employs an infrared laser. When irradiated with an infrared laser, molecules in the crosslinked relief-forming layer undergo molecular vibration, thus generating heat. When a high power laser such as a carbon dioxide laser or a YAG laser is used as the infrared laser, a large quantity of heat is generated in the laser-irradiated area, and molecules in the crosslinked relief-forming layer undergo molecular scission or ionization, thus being selectively removed, that is, engraved. The advantage of laser engraving is that, since the depth of engraving can be set freely, it is possible to control the structure three-dimensionally. For example, for an area where fine halftone dots are printed, carrying out engraving shallowly or with a shoulder prevents the relief from collapsing due to printing pressure, and for a groove area where a fine outline character is printed, carrying out engraving deeply makes it difficult for ink the groove to be blocked with ink, thus enabling breakup of an outline character to be suppressed.

In particular, when engraving is carried out using an infrared laser that corresponds to the absorption wavelength of the photothermal conversion agent, it becomes possible to selectively remove the crosslinked relief-forming layer at

higher sensitivity, thus giving a relief layer having a sharp image.

As the infrared laser used in the engraving step, from the viewpoint of productivity, cost, etc., a carbon dioxide laser (a $CO_2$ laser) or a semiconductor laser is preferable. In particular, a fiber-coupled semiconductor infrared laser (FC-LD) is preferably used. In general, compared with a $CO_2$ laser, a semiconductor laser has higher efficiency laser oscillation, is less expensive, and can be made smaller. Furthermore, it is easy to form an array due to the small size. Moreover, the shape of the beam can be controlled by treatment of the fiber.

With regard to the semiconductor laser, one having a wavelength of 700 to 1,300 nm is preferable, one having a wavelength of 800 to 1,200 nm is more preferable, one having a wavelength of 860 to 1,200 nm is futher preferable, and one having a wavelength of 900 to 1,100 nm is particularly preferable.

Furthermore, the fiber-coupled semiconductor laser can output laser light efficiently by being equipped with optical fiber, and this is effective in the engraving step in the present invention. Moreover, the shape of the beam can be controlled by treatment of the fiber. For example, the beam profile may be a top hat shape, and energy can be applied stably to the plate face. Details of semiconductor lasers are described in 'Laser Handbook 2nd Edition' The Laser Society of Japan, and 'Applied Laser Technology' The Institute of Electronics and Communication Engineers, etc.

Moreover, as plate making equipment comprising a fiber-coupled semiconductor laser that can be used suitably in the process for making a flexographic printing plate employing the flexographic printing plate precursor of the present invention, those described in detail in JP-A-2009-172658 and JP-A-2009-214334 can be cited.

The process for making a flexographic printing plate of the present invention may as necessary further comprise, subsequent to the engraving step, a rinsing step, a drying step, and/or a post-crosslinking step, which are shown below.

Rinsing step: a step of rinsing the engraved surface by rinsing the engraved relief layer surface with water or a liquid containing water as a main component.

Drying step: a step of drying the engraved relief layer.

Post-crosslinking step: a step of further crosslinking the relief layer by applying energy to the engraved relief layer.

After the above-mentioned step, since engraving residue is attached to the engraved surface, a rinsing step of washing off engraving residue by rinsing the engraved surface with water or a liquid containing water as a main component may be added. Examples of rinsing means include a method in which washing is carried out with tap water, a method in which high pressure water is spray-jetted, and a method in which the engraved surface is brushed in the presence of mainly water using a batch or conveyor brush type washout machine known as a photosensitive resin relief printing plate precursor, and when slime due to engraving residue cannot be eliminated, a rinsing liquid to which a soap or a surfactant is added may be used.

When the rinsing step of rinsing the engraved surface is carried out, it is preferable to add a drying step of drying an engraved relief layer so as to evaporate rinsing liquid.

Furthermore, as necessary, a post-crosslinking step for further crosslinking the relief layer may be added. By carrying out a post-crosslinking step, which is an additional crosslinking step, it is possible to further strengthen the relief formed by engraving.

The pH of the rinsing liquid that can be used in the present invention is preferably at least 9, more preferably at least 10, and yet more preferably at least 11. The pH of the rinsing liquid is preferably no greater than 14, more preferably no greater than 13.5, yet more preferably no greater than 13.1. When in the above-mentioned range, handling is easy.

In order to set the pH of the rinsing liquid in the above-mentioned range, the pH may be adjusted using an acid and/or a base as appropriate, and the acid or base used is not particularly limited.

The rinsing liquid that can be used in the present invention preferably comprises water as a main component.

The rinsing liquid may contain as a solvent other than water a water-miscible solvent such as an alcohol, acetone, or tetrahydrofuran.

The rinsing liquid preferably comprises a surfactant.

From the viewpoint of removability of engraving residue and little influence on a flexographic printing plate, preferred examples of the surfactant that can be used in the present invention include betaine compounds (amphoteric surfactants) such as a carboxybetaine compound, a sulfobetaine compound, a phosphobetaine compound, an amine oxide compound, and a phosphine oxide compound.

Furthermore, examples of the surfactant also include known anionic surfactants, cationic surfactants, amphoteric surfactants, and nonionic surfactants. Moreover, a fluorine-based or silicone-based nonionic surfactant may also be used in the same manner.

With regard to the surfactant, one type may be used on its own or two or more types may be used in combination.

It is not necessary to particularly limit the amount of surfactant used, but it is preferably 0.01 to 20 mass % relative to the total mass of the rinsing liquid, and more preferably 0.05 to 10 mass %.

The flexographic printing plate of the present invention having a relief layer on the surface of any substrate such as a surpport etc. may be produced as described above.

From the viewpoint of satisfying suitability for various aspects of printing, such as abrasion resistance and ink transfer properties, the thickness of the relief layer of the flexographic printing plate is preferably at least 0.05 mm but no greater than 10 mm, more preferably at least 0.05 mm but no greater than 7 mm, and yet more preferably at least 0.05 mm but no greater than 3 mm.
Furthermore, the Shore A hardness of the relief layer of the flexographic printing plate is preferably at least 50° but no greater than 90°. When the Shore A hardness of the relief layer is at least 50°, even if fine halftone dots formed by engraving receive a strong printing pressure from a letterpress printer, they do not collapse and close up, and normal printing can be carried out. Furthermore, when the Shore A hardness of the relief layer is no greater than 90°, even for flexographic printing with kiss touch printing pressure it is possible to prevent patchy printing in a solid printed part.
The Shore A hardness in the present specification is a value measured at 25°C by a durometer (a spring type rubber hardness meter) that presses an indenter (called a pressing needle or indenter) into the surface of a measurement target so as to deform it, measures the amount of deformation (indentation depth), and converts it into a numerical value.
The flexographic printing plate of the present invention is particularly suitable for printing by a flexographic printer using an aqueous ink, but printing is also possible when it is carried out by a relief printer using any of aqueous, oil-based, and UV inks, and printing is also possible when it is carried out by a flexographic printer using a UV ink. The flexographic printing plate of the present invention has excellent rinsing properties, there is less engraving residue, since a relief layer obtained has excellent elasticity aqueous ink transfer properties and printing durability are excellent, and printing can be carried out for a long period of time without plastic deformation of the relief layer or degradation of printing durability.

<u>Example</u>

The present invention is explained in further detail below by reference to Production Examples and Examples, but the present invention should not be construed as being limited to these Examples. Furthermore, 'parts' and '%' in the description below mean 'parts by mass' and 'mass%' unless otherwise specified. The number-average molecular weight (Mn) of a polymer in the Production Examples is a value measured by a GPC method unless otherwise specified.

<Production Example 1: Example of production of polymer A-1>

A separable flask equipped with a thermometer, a stirrer, and a reflux condenser was charged with 413.72 parts of 'KF-6003' (number-average molecular weight 5,100, OH value 22.0 mgKOH/g), which is a both-termini type carbinol-modified reactive silicone oil manufactured by Shin-Etsu Chemical Co., Ltd., and 11.05 parts of tolylene diisocyanate, a reaction was carried out by heating at 80°C for about 3 hours, following this 16.24 parts of 2-methacryloyloxyethyl isocyanate (Karenz 'MOI', Showa Denko K.K.) was added, and a reaction was carried out for a further approximately 3 hours, thus preparing polymer A-1 having a terminal methacryloyloxy group (ethylenically unsaturated groups in the molecule being on average about 2.0 per molecule) and a number-average molecular weight of about 8,000. This resin contained a siloxane bond in a main chain, was a syrup at 20°C, flowed when an external force was applied, and did not recover its original shape even when the external force was removed. That is, polymer A-1 was a plastomer at 20°C.

<Production Example 2: Example of production of polymer A-2>

A separable flask equipped with a thermometer, a stirrer, and a reflux condenser was charged with 447.24 parts of 'PCDL (registered trademark) L4672' polycarbonate diol (Asahi Kasei Chemicals Corporation; number-average molecular weight 1,990, OH value 56.4 mgKOH/g) and 30.83 parts of tolylene diisocyanate, a reaction was carried out by heating at 80°C for about 3 hours, following this 14.83 parts of 2-methacryloyloxyethyl isocyanate (Karenz 'MOI', Showa Denko K.K.) was added, and a reaction was carried out for a further approximately 3 hours, thus preparing polymer A-2 having a methacryloyloxy group at a main chain terminal (polymerizable unsaturated groups in the molecule being on average about 2.0 per molecule) and a number-average molecular weight of about 10,000.
This resin contained a urethane bond in a main chain, was a syrup at 20°C, flowed when an external force was applied, and did not recover its original shape even when the external force was removed. That is, polymer A-2 was a plastomer at 20°C.

<Production Example 3: Example of production of polymer A-3>

A separable flask equipped with a thermometer, a stirrer, and a reflux condenser was charged with 759.5 parts of 'GI-3000' hydrogenated polybutadiene diol (Nippon Soda Co., Ltd.; number-average molecular weight 3,940) and 46.21 parts of tolylene diisocyanate, a reaction was carried out by heating at 80°C for about 4 hours, following this 27.24 parts of 2-hydroxypropyl methacrylate was added, and a reaction was carried out for a further 3 hours, thus giving

polymer A-3 having a methacryloyloxy group at a main chain terminal (polymerizable unsaturated groups in the molecule being on average about 2.0 per molecule) and a number-average molecular weight of about 10,000.

Polymer A-3 was a syrup at 20°C, flowed when an external force was applied, and did not recover its original shape even when the external force was removed. That is, polymer A-3 was a plastomer at 20°C.

<Production Example 4: Example of production of polymer A-5>

A separable flask equipped with a thermometer, a stirrer, and a reflux condenser was charged with 447.24 parts of 'PCDL (registered trademark) L4672' polycarbonate diol (Asahi Kasei Chemicals Corporation; number-average molecular weight 1,990, OH value 56.4 mgKOH/g) and 30.83 parts of tolylene diisocyanate, a reaction was carried out by heating at 80°C for about 3 hours, following this 10.05 parts of *n*-butyl isocyanate (Wako Pure Chemical Industries, Ltd.) was added, and a reaction was carried out for a further approximately 3 hours, thus preparing polymer A-5 having a number-average molecular weight of about 9,000.

Polymer A-5 was a syrup at 20°C, flowed when an external force was applied, and did not recover its original shape even when the external force was removed.

<Production Example 5: Example of production of polymer A-6>

A separable flask equipped with a thermometer, a stirrer, and a reflux condenser was charged with 447.24 parts of 'PCDL (registered trademark) L4672' polycarbonate diol (Asahi Kasei Chemicals Corporation; number-average molecular weight 1,990, OH value 56.4 mgKOH/g) and 30.83 parts of tolylene diisocyanate, a reaction was carried out by heating at 80°C for about 3 hours, following this 13.49 parts of 2-acryloyloxyethyl isocyanate (Karenz 'AOI', Showa Denko K.K.) was added, and a reaction was carried out for a further approximately 3 hours, thus preparing a polymer having an acryloyloxy group at a main chain terminal (polymerizable unsaturated groups in the molecule being on average about 2.0 per molecule) and a number-average molecular weight of about 10,000. Following this 17.24 parts of 3-mercaptopropylmethyldimethoxysilane (KBM-802, Shin-Etsu Chemical Co., Ltd.) was added, and a reaction was carried out by heating at 40°C for 2 hours, thus giving polymer A-6 having a dialkoxysilyl group at a terminal and a number-average molecular weight of 10,000. Polymer A-6 was a syrup at 20°C, flowed when an external force was applied, and did not recover its original shape even when the external force was removed. That is, polymer A-6 was a plastomer at 20°C.

<Production Example 6: Example of production of polymer A-7>

A separable flask equipped with a thermometer, a stirrer, and a reflux condenser was charged with 447.24 parts of 'PCDL (registered trademark) L4672' polycarbonate diol (Asahi Kasei Chemicals Corporation; number-average molecular weight 1,990, OH value 56.4 mgKOH/g) and 30.83 parts of tolylene diisocyanate, a reaction was carried out by heating at 80°C for about 3 hours, following this 13.49 parts of 2-acryloyloxyethyl isocyanate (Karenz 'AOI', Showa Denko K.K.) was added, and a reaction was carried out for a further approximately 3 hours, thus preparing a polymer having an acryloyloxy group at a main chain terminal (polymerizable unsaturated groups in the molecule being on average about 2.0 per molecule) and a number-average molecular weight of about 10,000. Following this 18.77 parts of 3-mercaptopropyltrimethoxysilane (KBM-803, Shin-Etsu Chemical Co., Ltd.) was added, and a reaction was carried out by heating at 40°C for 2 hours, thus giving polymer A-7 having a terminal trialkoxysilyl group and a number-average molecular weight of 10,000. Polymer A-7 was a syrup at 20°C, flowed when an external force was applied, and did not recover its original shape even when the external force was removed. That is, polymer A-7 was a plastomer at 20°C.

<Production Example 7: Example of production of compound B-1>

A separable flask equipped with a thermometer, a stirrer, and a reflux condenser was charged with 162.91 parts of 2-methacryloyloxyethyl isocyanate (Karenz 'MOI', Showa Denko K.K.), 74.1 parts of 1-butanol (Tokyo Chemical Industry Co., Ltd.), and 0.023 parts of 2,6-di-*tert*-butyl-4-methylphenol (Tokyo Chemical Industry Co., Ltd.), and a reaction was carried out by heating at 80°C for about 3 hours, thus giving compound B-1.

<Production Example 8: Example of production of compound B-2>

A separable flask equipped with a thermometer, a stirrer, and a reflux condenser was charged with 162.91 parts of 2-methacryloyloxyethyl isocyanate (Karenz 'MOI', Showa Denko K.K.), 130.22 parts of 2-ethyl-1-hexanol (Tokyo Chemical Industry Co., Ltd.), and 0.029 parts of 2,6-di-*tert*-butyl-4-methylphenol (Tokyo Chemical Industry Co., Ltd.), and a reaction was carried out by heating at 80°C for about 3 hours, thus giving compound B-2.

<Production Example 9: Example of production of compounds B-3 to B-5>

Compound B-3 was obtained by the same reaction as in Production Example 8 except that the 2-ethyl-1-hexanol of Production Example 8 was replaced by an equimolar amount of triethylene glycol monomethyl ether (Tokyo Chemical Industry Co., Ltd.).

Compound B-4 was produced by the same reaction as in Production Example 8 except for replacement by equimolar amounts of 2-hydroxyethyl methacrylate and *n*-butyl isocyanate, and in the case of compound B-5 except for replacement by equimolar amounts of 2-hydroxyethyl methacrylate and ethoxycarbonylmethyl isocyanate.

(Example 1)

1. Preparation of resin composition 1 for flexographic printing plate

A three-necked round-bottom flask equipped with a stirring blade, a condenser, and a thermometer was charged with 100 parts of polymer A-1 as Component A synthesized in Production Example 1, 20 parts of the compound of Formula (B-1) as Component B, 1 part of Ketjen Black EC600JD (carbon black, Lion Corporation) as a photothermal conversion agent (Component C), 0.5 parts of Perbutyl Z (NOF Corporation) as a polymerization initiator, and 10 parts of propylene glycol monomethyl ether acetate as a solvent and stirred at 40°C for 30 minutes. By these operations, resin composition 1 for a flexographic printing plate was obtained.

2. Preparation of laser-engraving type flexographic printing plate precursor 1

A spacer (frame) having a predetermined thickness was placed on a PET substrate, and the resin composition 1 for a flexographic printing plate obtained above was cast gently so that it did not overflow from the spacer (frame) and dried in an oven at 70°C for 3 hours. Subsequently, it was heated at 80°C for 3 hours and at 100°C for a further 3 hours to thus carry out thermal crosslinking, thus providing a crosslinked relief-forming layer having a thickness of about 1 mm and producing laser-engraving type flexographic printing plate precursor 1.

3. Preparation of flexographic printing plate 1

After the spacer and the PET were removed and peeled off from laser-engraving type flexographic printing plate precursor 1, the relief-forming layer after crosslinking (crosslinked relief-forming layer) was subjected to engraving using the two types of laser below, thus giving flexographic printing plate 1.

Engraving by irradiation with laser was carried out using an ML-9100 series high quality $CO_2$ laser marker (Keyence) as a carbon dioxide laser engraving machine. A 1 cm square solid printed area was raster-engraved using the carbon dioxide laser engraving machine under conditions of an output of 12 W, a head speed of 200 mm/sec, and a pitch setting of 2,400 DPI.

As a semiconductor laser engraving machine, laser recording equipment provided with an SDL-6390 fiber-coupled semiconductor laser (FC-LD) (JDSU, wavelength 915 nm) with a maximum power of 8.0 W was used. A 1 cm square solid printed area was raster-engraved using the semiconductor laser engraving machine under conditions of a laser output of 7.5 W, a head speed of 409 mm/sec, and a pitch setting of 2,400 DPI.

The thickness of the relief layer of the flexographic printing plate was about 1 mm.

(Examples 2 to 16 and Comparative Examples 1 to 6)

Resin compositions for a flexographic printing plate, laser-engraving type flexographic printing plate precursors, and flexographic printing plates of Examples 2 to 16 and Comparative Examples 1 to 6 were obtained by the same method as in Example 1 except that Component A, Component B, and Component C used in Example 1 were replaced by the compounds shown in Table 1. Components A and C were replaced with respect to equivalent parts by mass and Component B was replaced with respect to an equimolar amount.

(Evaluation)

<Measurement of Tg of film>

The crosslinked relief-forming layer of the resin composition for a flexographic printing plate obtained was peeled off and used as a sample, and the temperature dependence of the storage modulus and the loss modulus was measured from -70°C to 100°C at 1Hz using a Rheogel-E4000 (UBM). The temperature dependence of tanδ was

determined from the storage modulus and the loss modulus, and the temperature at the top of the peak so obtained was defined as the Tg of the film. Measurement values are given together with the symbols G1 (good) when the Tg of the film was less than 20°C and G2 (poor) when it was equal to or greater than 20°C.

The measurement results are shown in Table 1.

<Evaluation of water resistance and solvent resistance>

Evaluation of water resistance and solvent resistance was carried as follows.

A flexographic printing plate precursor obtained above was cut into a 1 cm square sample and immersed in each of water and isopropyl alcohol (IPA) as solvents for 24 hours. Subsequently, the solvent was decanted and then removed by drying the sample at 120°C for 1 hour at normal pressure (1 atm). A change in weight of the sample between that before immersion and that after drying was calculated as an 'insolubilization ratio (%)'.

$$\text{Insolubilization ratio (\%)} = \text{(mass of sample after immersion and drying)} \div \text{(mass of sample before immersion)} \times 100$$

An insolubilization ratio of at least 90% was acceptable in terms of water resistance and solvent resistance.

<Evaluation of printing durability>

A flexographic printing plate that had been obtained was set in a printer (model ITM-4, Iyo Kikai Seisakujo Co., Ltd.), halftone printing was started using the aqueous ink Aqua SPZ16 Rouge (Toyo Ink Mfg. Co., Ltd.) as an ink without dilution and Full Color Form M 70 (Nippon Paper Industries Co., Ltd., thickness 100 μm) as printing paper, and completion of printing was defined as being when a halftone dot was not printed. In addition, evaluation of printing durability used a flexographic printing plate that had been subjected to laser engraving of a halftone pattern. The length (m) of paper printed up to the completion of printing was used as an index for printing durability. The larger the value, the better the evaluation of printing durability.

The results are shown in Table 1 below.

The parts by mass of Component B relative to 100 parts by mass of Component A is expressed as a numerical value in the column 'Ratio by mass of Component B and Component A (%)'.

The structures of Compounds B-1 to B-5 and compounds S-1 to S-4 of Component B are shown in Table 2. In Table 2, Me denotes a methyl group.

The components and other optional components used in the Examples and Comparative Examples were as follows.

(Component A)

Polymer A-1: polymer of Production Example 1
Polymer A-2: polymer of Production Example 2
Polymer A-3: polymer of Production Example 3
Polymer A-4: polycarbonate diol 'PCDL (registered trademark) L4672', Asahi Kasei Chemicals Corporation; number-average molecular weight 1,990, OH value 56.4 mgKOH/g, plastomer at 20°C
Polymer A-5: polymer of Production Example 4
Polymer A-6: polymer of Production Example 5
Polymer A-7: polymer of Production Example 6

(Component B)

B-1 to B-5 and S-1 to S-4: compounds B-1 to B-5 and compounds S-1 to S-4 shown in Table 2

(Component C)

Carbon black: Ketjen Black EC600JD, Lion Corporation

YKR-2100: near infrared absorbing dye, Yamamoto Chemicals Inc.
YKR-2900: near infrared absorbing dye, Yamamoto Chemicals Inc.

(Polymerization initiator)

Perbutyl Z: *t*-butyl peroxybenzoate, NOF Corporation

(Solvent)

Propylene glycol monomethyl ether acetate

Table 1

| | Component A | Urethane bond of Component A | Component B | Classification of Component B | Ratio by mass of Component B and Component A (%) | Component C | Film Tg (°C) Less than 20°C G1 (good) | Insolubilization ratio | | Printing durability (m) |
|---|---|---|---|---|---|---|---|---|---|---|
| | | | | | | | | Water (%) | IPA (%) | |
| Ex. 1 | | | B-1 | Formula (1) | 20 | Carbon black | -9 G1 | 99 | 98 | 117,000 |
| Ex. 2 | | | B-2 | Formula (1) | 20 | Carbon black | -18 G1 | 98 | 98 | 119,000 |
| Ex. 3 | Polymer A-1 | Yes | B-3 | Formula (1) | 20 | Carbon black | -20 G1 | 99 | 98 | 120,000 |
| Ex. 4 | | | B-4 | Formula (2) | 20 | Carbon black | -8 G1 | 98 | 97 | 115,000 |
| Ex. 5 | | | B-5 | Formula (2) | 20 | Carbon black | -14 G1 | 97 | 97 | 116,000 |
| Ex. 6 | Polymer A-2 | Yes | B-3 | Formula (1) | 20 | Carbon black | -19 G1 | 98 | 99 | 120,000 |
| Ex. 7 | Polymer A-3 | Yes | B-3 | Formula (1) | 20 | Carbon black | -24 G1 | 99 | 99 | 130,000 |
| Ex. 8 | Polymer A-4 | None | B-3 | Formula (1) | 20 | Carbon black | -19 G1 | 98 | 94 | 95,000 |
| Ex. 9 | Polymer A-5 | Yes | B-3 | Formula (1) | 20 | Carbon black | -17 G1 | 99 | 93 | 100,000 |
| Ex. 10 | Polymer A-1 | Yes | B-3 | Formula (1) | 20 | None | -15 G1 | 99 | 98 | 100,000 |
| Ex. 11 | Polymer A-6 | Yes | B-3 | Formula (1) | 20 | Carbon black | -21 G1 | 96 | 96 | 104,000 |
| Ex. 12 | Polymer A-7 | Yes | B-3 | Formula (1) | 20 | Carbon black | -17 G1 | 98 | 98 | 105,000 |
| Ex. 13 | Polymer A-1 | Yes | B-1 | Formula (1) | 35 | Carbon black | -24 G1 | 98 | 95 | 107,000 |
| Ex. 14 | Polymer A-1 | Yes | B-1 | Formula (1) | 45 | Carbon black | -30 G1 | 98 | 93 | 100,000 |
| Ex. 15 | Polymer A-1 | Yes | B-1 | Formula (1) | 20 | YKR-2900 | -15 G1 | 98 | 97 | 106,000 |
| Ex. 16 | Polymer A-1 | Yes | B-1 | Formula (1) | 20 | YKR- 2100 | -10 G1 | 98 | 98 | 105,000 |
| Comp. Ex. 1 | | | S-1 | | 20 | Carbon black | 30 G2 | 98 | 98 | 51,000 |
| Comp. Ex. 2 | | | S-2 | | 20 | Carbon black | 35 G2 | 96 | 95 | 50,000 |
| Comp. Ex. 3 | Polymer A-1 | Yes | S-3 | | 20 | Carbon black | -25 G1 | 89 | 71 | 63,000 |
| Comp. Ex. 4 | | | S-4 | | 20 | Carbon black | 45 G2 | 99 | 99 | 45,000 |
| Comp. Ex. 5 | | | B-1 | Formula (1) | 0.5 | Carbon black | 20 G2 | 98 | 97 | 60,000 |
| Comp. Ex. 6 | | | B-1 | Formula (1) | 60 | Carbon black | -41 G1 | 97 | 83 | 70,000 |

**Table 2**

| | Compound of Component B |
|---|---|
| Compound B-1 | 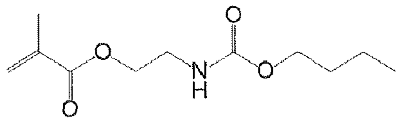 |
| Compound B-2 | 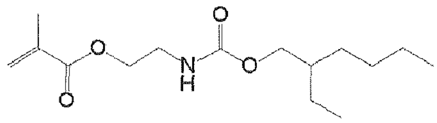 |
| Compound B-3 | 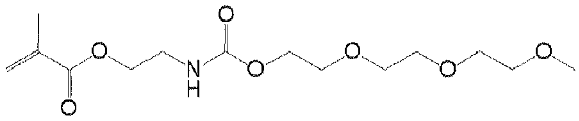 |
| Compound B-4 | 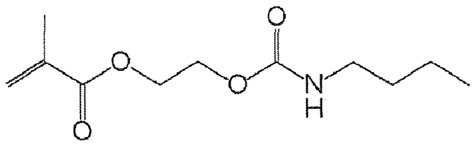 |
| Compound B-5 | 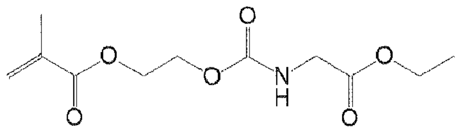 |
| Compound S-1 (Comparative compound) | 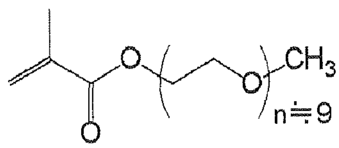 |
| Compound S-2 (Comparative compound) | 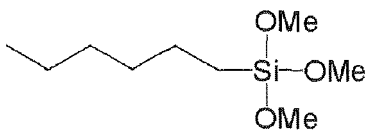 |
| Compound S-3 (Comparative compound) | 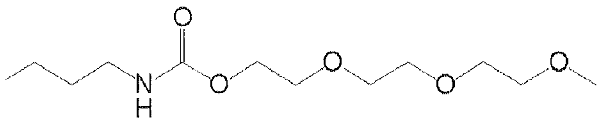 |
| Compound S-4 (Comparative compound) | 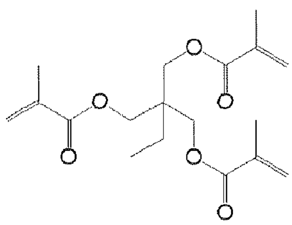 |

## Claims

**1.** A resin composition for a flexographic printing plate, comprising:

(Component A) a binder resin; and
(Component B) a compound represented by Formula (1) and/or Formula (2),
Component B being contained at 1 to 50 parts by mass relative to 100 parts by mass of Component A,

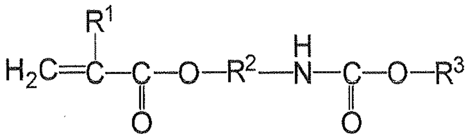 (1) 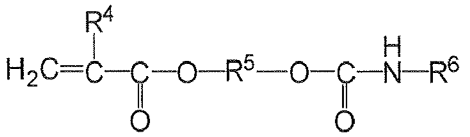 (2)

wherein in Formulae (1) and (2) $R^1$ and $R^4$ independently denote a hydrogen atom or a methyl group, $R^2$ and $R^5$ independently denote a divalent organic group having 1 to 20 carbons, and $R^3$ and $R^6$ independently denote a monovalent organic group having 1 to 20 carbons, $R^3$ and $R^6$ not comprising an ethylenically unsaturated group, a dialkoxysilyl group, or a trialkoxysilyl group.

**2.** The resin composition for a flexographic printing plate according to Claim 1, wherein Component A above comprises a urethane bond.

**3.** The resin composition for a flexographic printing plate according to Claim 1 or 2, wherein Component A comprises an ethylenically unsaturated group, a dialkoxysilyl group, or a trialkoxysilyl group.

**4.** The resin composition for a flexographic printing plate according to any one of Claims 1 to 3, wherein Component A is a plastomer at 20°C.

**5.** The resin composition for a flexographic printing plate according to any one of Claims 1 to 4, wherein Component A has a (meth)acryloyloxy group at both main chain termini.

**6.** The resin composition for a flexographic printing plate according to any one of Claims 1 to 5, wherein it further comprises (Component C) a photothermal conversion agent.

**7.** The resin composition for a flexographic printing plate according to Claim 6, wherein Component C is carbon black.

**8.** The resin composition for a flexographic printing plate according to any one of Claims 1 to 7, wherein it further comprises a polymerization initiator.

**9.** The resin composition for a flexographic printing plate according to any one of Claims 1 to 8, wherein it is a resin composition for a laser-engraving type flexographic printing plate.

**10.** A laser-engraving type flexographic printing plate precursor comprising a relief-forming layer comprising the resin composition for a flexographic printing plate according to any one of Claims 1 to 9.

**11.** A laser-engraving type flexographic printing plate precursor comprising a crosslinked relief-forming layer formed by crosslinking by means of light and/or heat a relief-forming layer comprising the resin composition for a flexographic printing plate according to any one of Claims 1 to 9.

**12.** A process for producing a laser-engraving type flexographic printing plate precursor, the process comprising:

a layer formation step of forming a relief-forming layer comprising the resin composition for a flexographic printing plate according to any one of Claims 1 to 9; and
a crosslinking step of crosslinking by means of light and/or heat the relief-forming layer to thus obtain a flexographic printing plate precursor comprising a crosslinked relief-forming layer.

**13.** The process for producing a laser-engraving type flexographic printing plate precursor according to Claim 12, wherein the crosslinking step is a step of crosslinking the relief-forming layer by means of heat to thus obtain a flexographic printing plate precursor comprising a crosslinked relief-forming layer.

**14.** A process for making a flexographic printing plate comprising, in this order:

a step of preparing a flexographic printing plate precursor for laser engraving comprising a crosslinked relief-forming layer formed by crosslinking by means of light and/or heat a relief-forming layer comprising the resin composition for a flexographic printing plate according to any one of Claims 1 to 9; and

an engraving step of laser-engraving the crosslinked relief-forming layer to thus form a relief layer.

**15.** Use of the resin composition for a flexographic printing plate according to any one of Claims 1 to 9 in a relief-forming layer of a flexographic printing plate precursor.

Europäisches Patentamt
European Patent Office
Office européen des brevets

# EUROPEAN SEARCH REPORT

Application Number
EP 13 15 1431

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2010/069749 A1 (AGFA GRAPHICS NV [BE]; DAEMS EDDIE [BE]; VANMAELE LUC [BE]) 24 June 2010 (2010-06-24) * page 26 - page 27; table 1 * | 1-15 | INV. C08L75/04 B41N3/00 C08G18/81 G03F7/035 |
| X,P | EP 2 537 675 A1 (AGFA GRAPHICS NV [BE]) 26 December 2012 (2012-12-26) * examples INV-01, INV-02; table 1 * | 1-15 | |
| Y | EP 1 936 438 A1 (AGFA GRAPHICS NV [BE]) 25 June 2008 (2008-06-25) * claims 1,9-10; example 2; table 3 * | 1-15 | |
| Y | EP 1 637 926 A2 (AGFA GEVAERT [BE] AGFA GRAPHICS NV [BE]) 22 March 2006 (2006-03-22) * claims 1-10; examples 1-2 * | 1-15 | |
| Y | WO 2005/103823 A1 (SHOWA DENKO KK [JP]; ISHIGAKI SATORU [JP]; ONISHI MINA [JP]; MUROFUSHI) 3 November 2005 (2005-11-03) * claims 1-14 * | 1-15 | TECHNICAL FIELDS SEARCHED (IPC) |
| A | JP 2009 190332 A (ASAHI KASEI E MATERIALS CORP) 27 August 2009 (2009-08-27) * abstract * | 1-15 | C08L B41N C08G G03F |

The present search report has been drawn up for all claims

1

| Place of search | Date of completion of the search | Examiner |
|---|---|---|
| Munich | 17 April 2013 | Scheuer, Sylvie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 13 15 1431

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2013

| Patent document cited in search report | Publication date | Patent family member(s) | Publication date |
|---|---|---|---|
| WO 2010069749 A1 | 24-06-2010 | CN 102256791 A | 23-11-2011 |
| | | EP 2199081 A1 | 23-06-2010 |
| | | JP 2012512762 A | 07-06-2012 |
| | | US 2011219972 A1 | 15-09-2011 |
| | | WO 2010069749 A1 | 24-06-2010 |
| EP 2537675 A1 | 26-12-2012 | EP 2537675 A1 | 26-12-2012 |
| | | WO 2012175445 A1 | 27-12-2012 |
| EP 1936438 A1 | 25-06-2008 | AT 460686 T | 15-03-2010 |
| | | EP 1936438 A1 | 25-06-2008 |
| | | ES 2340605 T3 | 07-06-2010 |
| | | US 2010009285 A1 | 14-01-2010 |
| | | US 2012213984 A1 | 23-08-2012 |
| | | WO 2008074796 A1 | 26-06-2008 |
| EP 1637926 A2 | 22-03-2006 | AT 429664 T | 15-05-2009 |
| | | CN 1749856 A | 22-03-2006 |
| | | EP 1637926 A2 | 22-03-2006 |
| | | ES 2324222 T3 | 03-08-2009 |
| | | JP 2006083385 A | 30-03-2006 |
| WO 2005103823 A1 | 03-11-2005 | NONE | |
| JP 2009190332 A | 27-08-2009 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009190332 A
- JP 28546954 B
- JP 4375705 B
- JP 2011510839 T
- JP 2011136430 A
- JP 2008063554 A
- JP 2009178869 A
- JP 2009204962 A
- JP 2009255510 A
- JP 46027926 B
- JP 51047334 B
- JP 57196231 A
- JP 59005240 A
- JP 59005241 A
- JP 2226149 A
- JP 1165613 A
- JP 2011136431 A
- JP 2009172658 A
- JP 2009214334 A


### Non-patent literature cited in the description


- Shinpan Kobunshi Jiten. Asakura Publishing Co., Ltd, 1988
- Senryo Binran. 1970
- Color Index (C.I.) Handbook, 'Saishin Ganryo Binran. 1977
- Saisin Ganryo Ouyogijutsu. CMC Publishing, 1986
- Insatsu Inki Gijutsu. CMC Publishing, 1984
- Laser Handbook. The Laser Society of Japan
- Applied Laser Technology. The Institute of Electronics and Communication Engineers